# EUROPEAN PATENT APPLICATION

(11) **EP 2 784 179 A1**
(43) Date of publication of application: **01.10.2014**
(21) Application number: 14161352.1
(22) Date of filing: 24.03.2014
(51) Int. Cl.: C23C 18/12, C23C 18/16, C23C 18/02

(54) **Deposition apparatus and method of recycling solution**

(30) Priority: 25.03.2013 KR 20130031708
(71) Applicant: Samsung SDI Co., Ltd., Yongin-si, Gyeonggi-do (KR)
(72) Inventor: Ahn, Sang-Hyuck, Gyeonggi-do (KR); Kim, Hyun-Chul, Gyeonggi-do (KR); Kim, Jeong-Hoon, Gyeonggi-do (KR); Cha, Si-Young, Gyeonggi-do (KR); Baik, Nam-Seok, Gyeonggi-do (KR)
(74) Representative: Mounteney, Simon James

(57) **Abstract**

A deposition apparatus and a method for recycling a solution. The deposition apparatus includes a bath in which a solution used in a chemical bath deposition (CBD) method is filled, a tank in which the solution used in the CBD method is temporarily stored, and a filter unit for filtering the solution stored in the tank to be reused in the CBD method again. Thus, when a buffer layer is formed by the CBD method, the number of times of reusing the solution for forming the buffer layer may be increased.

## Description

### BACKGROUND

### 1. Field

The embodiments of the present invention relate to a deposition apparatus and a method of recycling a solution.

### 2. Description of the Related Art

As existing energy resources such as petroleum or coal gets exhausted, interest is increasing in various energy resources that can replace the existing energy resources. Solar cells using p-n junction of semiconductor devices are considered as next generation batteries by converting solar energy into electrical energy.

Solar cells may be classified according to their materials, such as crystalline or amorphous silicon solar cells, compound solar cells, and/or die-sensitized solar cells, of which the crystalline silicon solar cells are widely used. However, the material cost for crystalline silicon solar cells can be expensive and the manufacturing process may be relatively complicated for the amount of electricity that can be generated. To address this problem, interest is increasing in thin film solar cells having cheaper production costs. Among such thin film solar cells, researches on thin film solar cells including Cu-In-Se (CIS) based or Cu-In-Ga-Se (CIGS)-based semiconductor compounds having high photoelectric conversion efficiency are being conducted actively.

In CIS-based solar cells, a photoelectric conversion layer formed with the CIS compound and a light transmissive electrode layer formed on the photoelectric conversion layer form a p-n junction, and a buffer layer is formed between the photoelectric conversion layer and the light transmissive electrode layer. Here, the buffer layer may be formed of cadmium sulfide (CdS). However, since the CdS contains cadmium (Cd) that is harmful to the human body, attempts have been made to use zinc sulfide (ZnS) as the buffer layer.

Meanwhile, when the buffer layer is formed using a method such as a chemical bath deposition (CBD) process, a processing solution that is used for forming the buffer layer is used repeatedly for the CBD process. Over the course of repeatedly reusing the processing solution, colloids of ZnS or zinc oxide are generated in the ZnS solution, and thus, there is limit as to the number of times the same processing solution can be reused.

### SUMMARY

Aspects of embodiments of the present invention are directed toward a deposition apparatus capable of increasing the number of times of using a solution when a buffer layer is formed by using a chemical bath deposition method, and a method of recycling the solution.

Additional aspects will be set forth in part in the description which follows, and in part, will be apparent from the description, or may be learned by practice of the presented embodiments.

According to one or more embodiments of the present invention, a deposition apparatus includes a bath configured to hold a solution usable for a chemical bath deposition (CBD) process, a tank configured to temporarily store the solution, a first pipe configured to fluidly couple the tank and the bath, a discharge pump at the first pipe and, and configured to move the solution through at least the first pipe from the bath to the tank, a filter unit configured to filter the solution stored in the tank, and a second pipe configured to fluidly couple the tank and the bath, the second pipe including a circulation pump and the filter unit, wherein the circulation pump is configured to move the solution from the tank to the bath via the filter unit, through at least the second pipe.

The tank may be configured to heat the solution stored in the tank to a temperature higher than that of the solution in the bath.

The apparatus may be configured to move the solution from the bath to the tank when a light transmittance of the solution in the bath is about 60% or less.

The deposition apparatus may further include a first valve at the first pipe, and a second valve at the second pipe, wherein the first valve and the second valve are configured to operate exclusively when moving the solution.

The deposition apparatus may further include a circulation pipe configured to fluidly couple the second pipe and the tank.

The circulation pipe may be configured to move a cleaning solution, and the cleaning solution may be adapted to clean the filter unit and the tank.

The deposition apparatus may further include a circulation pump at the circulation pipe configured to circulate the cleaning solution.

The deposition apparatus may further include an injection pipe fluidly coupled with the tank, the injection pipe being configured to inject the cleaning solution into the tank.

The cleaning solution may be deionized water.

A buffer layer of a solar cell may be formed by utilizing the CBD process.

According to another aspect of the present invention, a method of recycling a solution includes performing a chemical bath deposition (CBD) process by dipping a substrate in a bath including the solution, determining a light transmittance of the solution, stopping the CBD process and moving the solution from the bath to a tank, when the determined light transmittance of the solution is about 60% or less, and filtering the solution and moving the filtered solution from the tank back to the bath.

When the determined light transmittance of the solution is about 60% or less, the moving the solution from the bath to the tank may be moved through a first pipe, the moving the filtered solution from the tank to the bath may be moved through a second pipe, and the filtering the solution may be performed by a filter unit on the second pipe.

The method may further include restarting the CBD process when the filtered solution is moved from the tank to the bath.

The method may further include cleaning the tank and the filter unit after restarting the CBD process.

The cleaning the tank and the filter unit may include moving a cleaning solution through a circulation pipe, the circulation pipe fluidly coupling the second pipe and the tank.

The cleaning the tank and the filter unit may include performing a first cleaning process utilizing an aqueous acid, and performing a second cleaning process utilizing deionized water.

The method may further include setting a temperature of the solution in the tank to a higher temperature than that of the solution in the bath.

The method may further include operating exclusively, a first valve at the first pipe and a second valve at the second pipe.

The above aspects of the invention are set out in claims 1 to 15.

### BRIEF DESCRIPTION OF THE DRAWINGS

The aspects of the present disclosure will become apparent and more readily appreciated from the following description of the embodiments, taken in conjunction with the accompanying drawings of which:
FIG. 1 is a cross-sectional view of a solar cell according to an embodiment of the present invention;
FIG. 2 is a diagram of a deposition apparatus according to an embodiment of the present invention;
FIG. 3 is a flowchart illustrating a process of recycling a solution by using the deposition apparatus of FIG. 2;
FIG. 4 is a diagram showing a variation in a light transmittance of a CBD solution through a filtering operation;
FIG. 5 is a diagram showing efficiency of a solar cell when a buffer layer is formed by successively using a filtered CBD solution;
FIG. 6 is a diagram of the deposition apparatus according to another embodiment of the present invention; and
FIG. 7 is a flowchart illustrating a process of recycling a solution by using the deposition apparatus of FIG. 6.

### DETAILED DESCRIPTION

As the embodiments of the present invention allow for various changes and numerous embodiments, some embodiments will be illustrated in the drawings and described in detail in the written description. However, this is not intended to limit the embodiments of the present invention to particular modes of practice, and it is to be appreciated that all changes, equivalents, and substitutes that do not depart from the technical scope of the present invention are encompassed in the present invention. In the description of the embodiments of the present invention, certain detailed explanations of related art are omitted when it is deemed that they may unnecessarily obscure the essence of the various embodiments of the present invention.

While terms such as "first," "second," etc., may be used to describe various components, such components may not necessarily be limited to the above terms. The above terms are used to distinguish one component from another.

The terms used in the present specification are merely used to describe some embodiments, and are not intended to limit the embodiments of the present invention. An expression used in the singular may also encompass the expression of the plural, unless it has a clearly different meaning in the context. In the present specification, it is to be understood that the terms such as "including" or "having" are intended to indicate the existence of the features, numbers, steps, actions, components, parts, or combinations thereof disclosed in the specification, and are not intended to preclude the possibility that one or more other features, numbers, steps, actions, components, parts, or combinations thereof may exist or may be added.

Embodiments of the present invention will be described in more detail with reference to accompanying drawings.

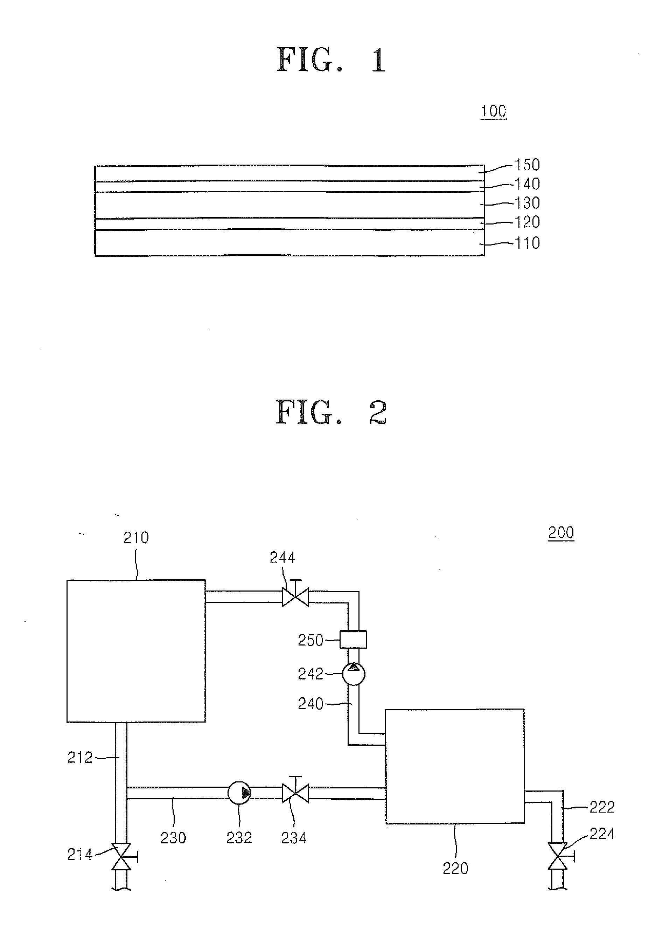

FIG. 1 shows a cross-sectional view of a solar cell 100 according to an embodiment of the present invention.

Referring to FIG. 1, the solar cell 100 of the described embodiment includes a substrate 110, and a rear electrode layer 120, a light absorbing layer 130, a buffer layer 140, and a light transmitting electrode layer 150 that are sequentially formed on the substrate 110.

The substrate 110 is formed of a glass material and/or a polymer material having high light transmittance. For example, a glass substrate may be formed of soda-lime glass, and a polymer substrate may be formed of polyimide. However, the embodiments of the present invention are not necessarily limited thereto. In some embodiments, a glass substrate may also, or instead, be formed of low-iron tempered glass to protect internal devices against external shock and to increase transmittance of solar light. In some embodiments, low-iron soda-lime glass can elute Na ions in the glass at a processing temperature of about 500°C or higher, thereby improving efficiency of the light absorbing layer 130 formed with CIGS.

The rear electrode layer 120 is formed of a metallic material having good electric conductivity and light reflectivity such as, for example, molybdenum (Mo), aluminum (Al), or copper (Cu), so as to collect charges generated due to photoelectric conversion effect and to reflect light transmitted through the light absorbing layer 130 to be absorbed by the light absorbing layer 130. In some embodiments, the rear electrode layer 120 may contain Mo in consideration of high electric conductivity, an ohmic contact to the light absorbing layer 130, and high temperature stability under selenium (Se) atmosphere.

The rear electrode layer 120 is doped with alkaline ions such as Na. For example, when growing the CiGS light absorbing layer 130, alkaline ions doped on the rear electrode layer 120 are mixed in the light absorbing layer 130 so as to favorably affect the light absorbing layer 130, and to improve electric conductivity of the light absorbing layer 130. As such, an open-circuit voltage Voc of the solar cell 100 may increase, thereby improving efficiency of the solar cell 100.

In some embodiments, the rear electrode layer 120 is formed to have a multi-layered structure in order to bond to the substrate 110, and to ensure resistive property of the rear electrode layer 120.

The light absorbing layer 130 is formed of a Cu-In-Se (CIS)-based compound including copper (Cu), indium (In), and Se to form a p-type semiconductor layer for absorbing incident solar ray. In some embodiments, the light absorbing layer 130 is formed of Cu(In, Ga) Se₂ (CIGS)-based compound including Cu, In, Ga, and Se.

In some embodiments, the light absorbing layer 130 is formed by using a co-evaporation method, in which Cu, In, Ga, and Se, for example, are put into an electric furnace provided in a vacuum chamber and are heated for vacuum deposition, or sputtering/selenization, in which a CIG-based metal precursor film is formed on the rear electrode layer 120 by using a Cu target, an In target, and a Ga target, and is annealed under a H₂Se gas atmosphere so that the metal precursor film reacts with Se to form the CIGS-based light absorbing layer 130. In some embodiments, the light absorbing layer 130 is formed by using an electro-deposition method or a molecular organic chemical vapor deposition (MOCVD) method.

The buffer layer 140 reduces a band gap difference between the light absorbing layer 130 and the light transmitting electrode layer 150, and therefore reduces recombination of electrons and holes, which may occur at interfaces between the light absorbing layer 130 and the light transmitting electrode layer 150. The buffer layer 140 may be formed of, for example, zinc sulfide (ZnS); however, the present invention is not limited thereto.

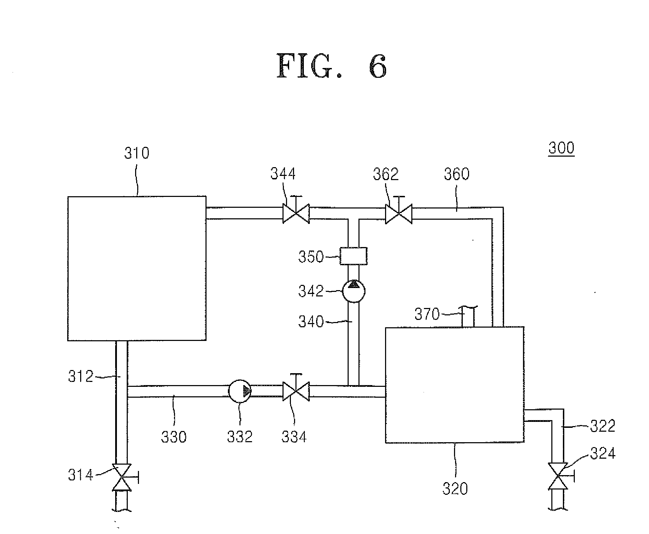

In some embodiments, the buffer layer 140 is formed in a chemical bath deposition (CBD) process by using a deposition apparatus shown, for example, in FIG. 2 or FIG. 6, which will be described in more detail later.

The light transmitting electrode layer 150 forms a P-N junction with the light absorbing layer 130. In some embodiments, the light transmitting electrode layer 150 is formed of a transparent conductive material such as, for example, ZnO:B, ZnO:Al, ZnO:Ga, indium tin oxide (ITO), or indium zinc oxide (IZO) to capture charges formed by a photoelectric conversion effect.

In some embodiments, an upper surface of the light transmitting electrode layer 150 is textured in order to reduce reflection of incident solar ray and increase light absorption of the light absorbing layer 130.

In some embodiments, the solar cell 100 is partitioned into a plurality of solar cell units through a first scribing process for isolating the rear electrode layer 120, a second scribing process for isolating the light absorbing layer 130 and the buffer layer 140, and a third scribing process for isolating the rear electrode layer 120, the light absorbing layer 130, and the buffer layer 140. The plurality of solar cell units may be connected to each other serially (e.g., in series).

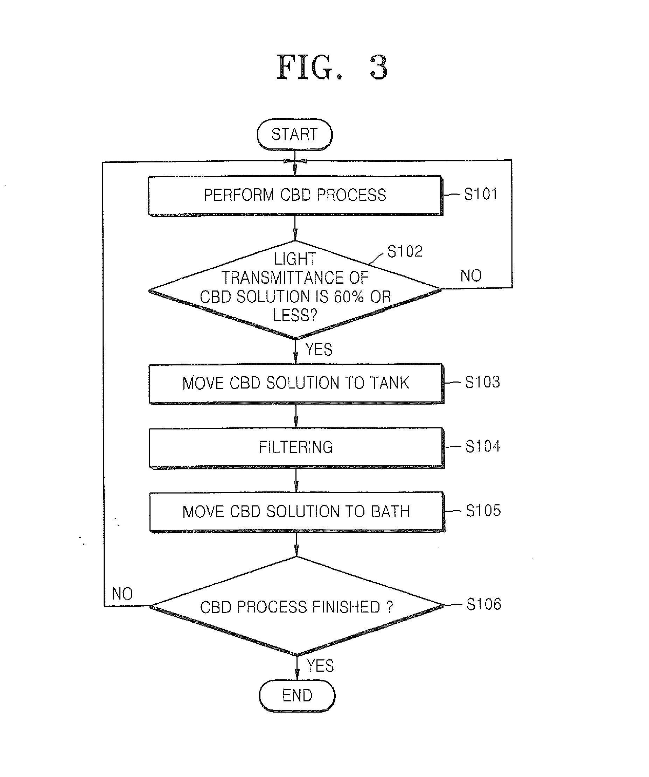

FIG. 2 shows a diagram of a deposition apparatus according to an embodiment of the present invention, and FIG. 3 is a flowchart illustrating the process for recycling the solution by using the deposition apparatus of FIG. 2.

According to an embodiment of the present invention, FIG. 2 shows a deposition apparatus 200 for forming, for example, the buffer layer (140 of FIG. 1) in the solar cell 100 of FIG. 1 by using the CBD method. FIG. 3 shows the process of recycling solution that may be used for forming, for example, the buffer layer 140 of FIG. 1.

The deposition apparatus 200 includes a bath 210 filled with a solution for forming, for example, the buffer layer (140 of FIG. 1), a tank 220 for temporarily storing the solution used in the CBD process, and a filter unit 250 for filtering the solution stored in the tank 220.

The bath 210 and the tank 220 are fluidly connected with each other via a first pipe 230, and the solution used in the CBD process is moved or transferred from the bath 210 to the tank 220 through the first pipe 230. A discharge pump 232 and a first valve 234 are formed on the first pipe 230 to prevent backflow of the solution used in the CBD process.

According to an embodiment of the present disclosure, the solution temporarily stored in the tank 220 is introduced into the bath 210 after passing through the filter unit 250. The filter unit 250 is formed at (or with) a second pipe 240 that fluidly connects the tank 220 to the bath 210, and a circulation pump 242 and a second valve 244 are formed at (or with) the second pipe 240 to prevent or reduce backflow of the filtered solution.

According to an embodiment of the present disclosure, the filter unit 250 includes a porous filter formed of, for example, polypropylene (PP), polyethersulfone (PES), Teflon (PTFE), or nylon, and an aperture of the filter has a size of about 0.2 µm to about 5 µm. However, the present invention is not limited thereto.

According to an embodiment of the present disclosure, the bath 210 is fluidly connected to a third pipe 212. A third valve 214 is formed at the first pipe 212. The solution may be injected into the bath 210 or may be drained to the outside through the third pipe 212.

The process of recycling the solution for forming, for example, the buffer layer 140 (refer to FIG. 1) will be described with reference to FIGS. 2 and 3.

According to an embodiment of the present disclosure, the CBD process starts by first, dipping a substrate 110 (refer to FIG. 1) in the bath 210 containing the solution for forming the buffer layer 140 (hereinafter, referred to as a CBD solution) (S101). The buffer layer 140 is formed on the light absorbing layer 130 as previously described with reference to FIG. 1.

The CBD solution may include, for example but not limited to, zinc, sulfur, and/or ammonium hydroxide (NH₄OH), and the bath 210 includes a heater so as to maintain a temperature of the CBD solution at about 60°C to about 80°C. According to an embodiment, the substrate 110 (refer to FIG. 1) is dipped in the CBD solution for a set or predetermined time period, and a zinc sulfide (ZnS) film is formed on the light absorbing layer 130 (refer to FIG. 1) on the substrate 110 by combination of Zn²⁺ ions and S²⁻ ions.

When the buffer layer 140 (e.g., ZnS buffer layer) is formed, the substrate 110 on which the buffer layer 140 is formed is withdrawn out of the bath 210, and a new substrate 110 (or another substrate) on which a buffer layer 140 to be formed is dipped in the CBD solution. That is, the same CBD solution is reused to form buffer layers on other substrates.

When the ZnS buffer layer is successively formed on the new substrate 110 by using the same CBD solution, a concentration of impurities such as colloids of ZnS or ZnO in the CBD solution increase as the number of times of reusing the CBD solution increases. When these impurities become attached to the substrate 110 during the forming of the buffer layer 140, the characteristics of the solar cell 100 (refer to FIG. 1) become degraded, and efficiency of the solar cell 100 is lowered. Thus, in some embodiments, the CBD solution is replaced with a new solution to keep the concentration of these impurities low. According to another embodiment of the present disclosure, the CBD solution is recycled without replacing it.

Light transmittance of the CBD solution during initial stages is around 100%. As the number of times of using the CBD solution is increased, the light transmittance of the CBD solution is reduced due to the increased concentration of impurities. According to some experiments, the CBD solution may be successively reused about six to eight times without substantially affecting the efficiency of the solar cell 100. The light transmittance of the CBD solution at that time was measured to be about 60% or greater. That is, in one embodiment, if the light transmittance of the CBD solution is about 60% or less, characteristics of the formed buffer layer 140 are degraded due to the increased concentration of the impurities in the CBD solution.

According to an embodiment of the present disclosure, the light transmittance of the CBD solution is measured when one CBD process is finished. Thus, for example, even though the measured light transmittance of the CBD solution is still be greater than about 60% when the CBD process starts for a substrate 110, if it is predicted that the light transmittance of the CBD solution would lower to about 60% or less by the time the CBD process of the substrate 110 is finished, it may be assumed or determined that the light transmittance of the CBD solution of the corresponding process is about 60% or less. The light transmittance of the CBD solution may be predicted by considering the amount of time it takes for performing one CBD process, and a lowered value of the light transmittance during the time period of the one CBD process.

According to an embodiment of the present disclosure, it is determined whether the light transmittance of the CBD solution is about 60% or less (S102). When the light transmittance of the CBD solution determined to be about 60% or less, the CBD solution in the bath 210 is moved to the tank 220 (S103).

According to an embodiment of the present disclosure, the second valve 244 is shut, and the first valve 234 is opened. That is, the first valve 234 and the second valve 244 are in opposite valve positions. Thus, the used CBD solution is moved or transferred to the tank 220 along the first pipe 230 by the discharge pump 232.

According to an embodiment of the present disclosure, the tank 220 temporarily stores the CBD solution that is used during the process. The tank 220 includes a heater to maintain a temperature of about 2°C to about 10°C higher than a film forming temperature of the buffer layer 140 during the CBD process, to compensate for the temperature dropping when the CBD solution 210 is introduced into the bath 210 via the second pipe 240.

According to an embodiment of the present disclosure, a drainage pipe 222 is formed at a side of the tank 220 to discharge the CBD solution that is to be discarded by opening a drainage valve 224 formed on the drainage pipe 222. When the CBD solution is discarded, a new CBD solution may be filled in the bath 210 via the third pipe 212.

According to an embodiment of the present disclosure, the CBD solution stored in the tank 220 is filtered by the filter unit 250 and introduced into the bath 210 again (S104 and S105).

According to an embodiment of the present disclosure, the first valve 234 is locked or shut, and the second valve 244 is opened, and the CBD solution stored in the tank 220 is introduced into the bath along the second pipe 240 by the circulation pump 242. That is, the first valve 234 and the second valve 244 are in opposite valve positions when moving the CBD solution (e.g., transferring the solution from one location to another location).

According to an embodiment of the disclosure, the filter unit 250 filters the CBD solution stored in the tank 220 to eliminate the impurities. Accordingly, the light transmittance of the CBD solution may be increased again, and thus, the number of times that the CBD solution for forming the buffer layer 140 may be used is increased.

According to an embodiment of the present disclosure, most, or all of the CBD solution in the bath 210 is first moved or transferred to the tank 220 before the filtering is performed. Thus, the filtered CBD solution from the tank 220 and the existing CBD solution in the bath 210 are not mixed. Thus, the time it takes to perform the filtering may be reduced. To the contrary, if the filtering is performed during the CBD process without first moving or transferring the CBD solution to the tank 220, the CBD solution in the bath 210 will flow continuously, and an uneven thickness of the buffer layer 140 may be formed.

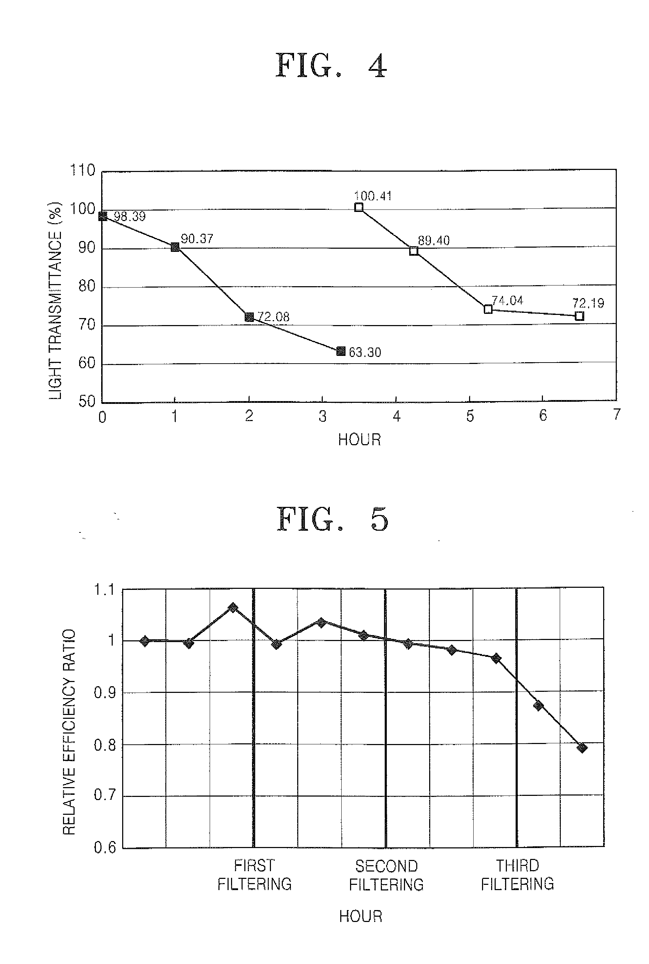

FIG. 4 is a diagram showing an example variation in the light transmittance of the CBD solution according to the filtering operation, and FIG. 5 is a diagram showing efficiency of the solar cell 100 when the buffer layer 140 is formed by using the filtered CBD solution.

In the example of FIG. 4, the light transmittance of the CBD solution was measured every hour, and each CBD process took about 30 minutes. That is, the CBD process was performed six times before performing a first filtering operation. As shown in FIG. 4, it may be predicted that the light transmittance of the CBD solution at a time point when a seventh CBD process is finished (or after about 3.5 hours) would be about 60% or less if the seventh CBD process is performed without performing the filtering operation. Therefore, the first filtering operation is performed after performing the CBD process six times, so that the filtering operation is performed before the light transmittance of the CBD solution lowers to less than about 60%.

As shown in the example of FIG. 4, after the first filtering operation is performed, the light transmittance of the CBD solution is recovered to about 100%, and the CBD process may be performed again for about three hours. That is, successively about six more times, after the first filtering. The light transmittance of the CBD solution was further recovered after performing a second filtering operation, the results which may be seen in FIG. 5.

FIG. 5 shows efficiency of the solar cell 100 when the buffer layer 140 is formed by using the CBD solution shown in FIG. 4.

In the example shown in FIG. 5, the filtering operation is performed three times, and the efficiency of the solar cell 100 that is manufactured by using first, third, and fifth substrates 110 before a first filtering operation, first, third, and fifth substrates 110 between the first filtering operation and a second filtering operation, first, third, and fifth substrates 110 between the second filtering operation and a third filtering operation, and a first and third substrate 110 after the third filtering operation are measured. The relative efficiency ratio of FIG. 5 is measured based on the efficiency of the solar cell 100 that is manufactured by using the first substrate 110 before the first filtering operation.

As shown in FIG. 5, the efficiency of the solar cell 100 including the buffer layer 140 that is formed by using the CBD solution before the third filtering operation is maintained at about 95% or higher with respect to that of the solar cell 100 including the buffer layer 140 that is formed by using the initial CBD solution. Therefore, by filtering the CBD solution, the available number of times of using the CBD solution may be increased.

However, the efficiency of the solar cell 100 rapidly decreases after the third filtering operation because the concentration of the CBD solution is reduced and composition of the CBD solution is changed.

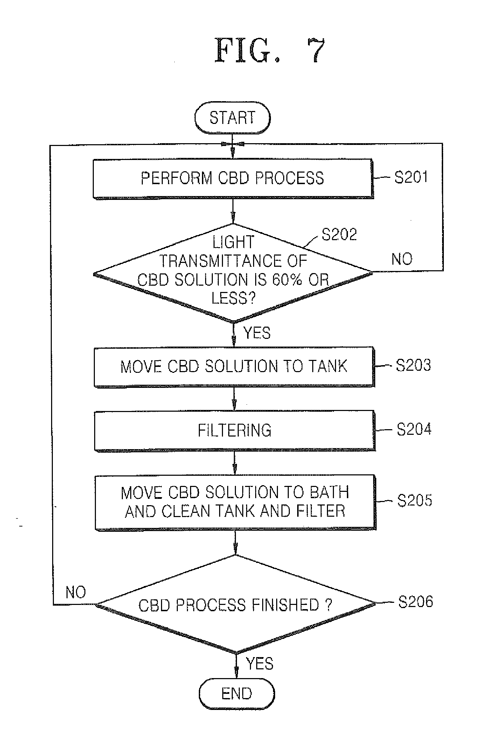

FIG. 6 is a diagram showing another example of the deposition apparatus according to an embodiment of the present disclosure. FIG. 7 is a flowchart illustrating the process of recycling a solution by using, for example, the deposition apparatus 300 of FIG. 6.

According to an embodiment of the present disclosure, the deposition apparatus 300 shown in FIG. 6 includes a bath 310 which is filled with a CBD solution, a tank 320 for temporarily storing the used CBD solution, a filter unit 350 for filtering the CBD solution stored in the tank 320, and a circulation pipe 360 for cleaning the tank 320 and the filter unit 350.

The bath 310, the tank 320, and the filter unit 350 are the same as the bath 210, the tank 220, and the filter unit 250 shown in FIGS. 2 and 3, and thus, the detailed descriptions thereof are not provided here.

According to an embodiment of the present disclosure, the deposition apparatus 300 of FIG. 6 further includes the circulation pipe 360. The circulation pipe 360 connects the tank 320 and a second pipe 340 to each other, and a fourth valve 362 may be formed on the circulation pipe 360.

According to an embodiment of the present disclosure, an injection pipe 370 for introducing a cleaning solution is further formed on the tank 320. The cleaning solution is injected into the tank 320 through the injection pipe 370, and the cleaning solution can circulate through the second pipe 340, the circulation pipe 360, and the tank 320 to clean the impurities of the CBD solution remaining in the tank 320, the second pipe 340, and the filter unit 350. Thus, the filter unit 350 may be replaced less frequently, and the amount of impurities remaining in the tank 320 and the second pipe 340 may be reduced or eliminated. Thus, the deposition apparatus 300 may be used in a more efficient manner.

The above described cleaning process may be performed concurrently during the CBD process. That is, since a first valve 334, a second valve 344, and a third valve 314 are locked when the CBD process is performed, the CBD process is not affected by the cleaning process even when the cleaning process is performed while opening the fourth valve 362.

According to an embodiment, because the cleaning solution that may remain in the second pipe 340 or the filter unit 350 after the cleaning process, may affect properties of the CBD solution, deionized water (DIW) that does not affect the properties of the CBD solution is used as the cleaning solution.

According to an embodiment of the present disclosure, for performing the cleaning process more efficiently, a first cleaning process is performed by using aqueous acid that dissolves ZnS, followed by a second cleaning process that is performed by using the DIW. When the first cleaning process is performed by using the aqueous acid, the impurities in the filter unit 350 may be removed more efficiently, and accordingly, the filtering effect of the filter unit 350 may not degrade even when the number of filtering operations increases. Thus, the light transmittance of the CBD solution may be improved, and the filter unit 350 may be replaced less frequently.

The cleaning solution used in the cleaning process is drained to outside of the tank 320 via the drainage pipe 322 from the tank 320.

Hereinafter, the process of recycling the CBD solution will be described below with reference to FIG. 7, and also with FIGS. 1 and 6.

According to an embodiment of the present disclosure, a CBD process is performed (S201). The CBD process may start when a substrate 110 on which a light absorbing layer 130 is formed is dipped in the bath 310 in which the CBD solution is filled. The CBD solution may include, for example, zinc, sulfur, and NH₄OH, and may be maintained at a processing temperature of about 60°C to about 80°C.

During the CBD process, the buffer layer 140 may be successively formed using the same CBD solution, and as the number of times of reusing the same CBD solution increases, the concentration of impurities in the CBD solution increases and the light transmittance of the CBD solution is lowered.

That is, as described above with reference to FIG. 3, when the light transmittance of the CBD solution is less than about 60%, the characteristics of the formed buffer layer 140 may be degraded due to the increase in the concentration of impurities in the CBD solution. Thus, it is determined whether the light transmittance of the CBD solution is about 60% or less during the CBD process (S202). If the light transmittance of the CBD solution is about 60% or less, the CBD process is stopped, and the CBD solution in the bath 310 is moved or transferred to the tank 320 (S203).

According to an embodiment of the present disclosure, the third valve 314, the second valve 344, and the fourth valve 362 are locked or shut, and the first valve 334 is opened. The CBD solution may be moved or transferred to the tank 320 through the first pipe 330, while preventing or reducing backflow by the discharge pump 332.

In some embodiments, the tank 320 includes a heater to maintain a temperature that is higher than that of the bath 310. For example, the tank 320 may be configured by the heater to maintain the temperature of the CBD solution in the tank 320 to be about 2°C to about 10°C higher than a film forming temperature. The CBD solution is moved or transferred via the second pipe 340 to be filtered by the filter unit 350 (S204).

The first valve 334 and the fourth valve 362 are locked or shut, and the second valve 344 is opened to move or transfer the CBD solution stored in the tank 320 to the bath 310 through the second pipe 340 by the circulation pump 342 (S205). Through this process of filtering the CBD solution, the light transmittance of the CBD solution is recovered, and thus, the CBD solution may now be reused more number of times for forming the buffer layer 140.

When the CBD solution is finished being moved or transferred to the bath 310, the second valve 344 is locked or shut and the fourth valve 362 is opened so that the cleaning solution may be introduced into the tank 320 through the injection pipe 370. The cleaning solution injected into the tank 320 circulates through the second pipe 340 and the circulation pipe 360 by the circulation pump 342 to remove the impurities in the CBD solution remaining in the tank 320 and the filter unit 350 (S205).

According to an embodiment of the present disclosure, the above described cleaning process is performed while the CBD process is also being performed, unless the CBD process is already finished. That is, during the CBD process, the third valve 314, the first valve 334, and the second valve 344 are locked or shut, and thus, the CBD process is not affected by the cleaning process even when the cleaning process is performed with the fourth valve 362 open.

In some embodiments, the cleaning solution is DIW so that it does not affect the CBD solution. Therefore, although some DIW may remain in the second pipe 340 or the filter unit 350 after finishing the cleaning process, the properties of the CBD solution are not affected because the cleaning solution is DIW. Additionally, an amount of the DIW remaining in the second pipe 340 or the filter unit 350 is too small to affect the concentration of the CBD solution, and thus may be considered to be negligible.

In some embodiments, a first cleaning process may be performed by using aqueous acid that may dissolve ZnS, followed by a second cleaning process that may be performed by using the DIW in order to perform the cleaning more efficiently.

When a concentration of the aqueous acid is greater than, for example, about125 mM, the tank 320, the second pipe 340, the filter unit 350, and the circulation pipe 360 may become corroded. On the other hand, when the concentration of the aqueous acid is less than about 5 mM, it may be difficult to reduce an amount of time it takes for performing the cleaning process. Thus, the concentration of the aqueous acid may range from about 5 mM to about 125 mM. The aqueous acid may include, for example, but not necessarily be limited to, hydrochloric acid, nitric acid, sulfuric acid, fluoric acid, and acetic acid.

When the first cleaning process is performed by using the aqueous acid as described above, the impurities remaining in the filter unit 350 may be removed efficiently. Accordingly, the filtering effect of the filter unit 350 may be maintained even when the number of filtering operations increases, and thus, the light transmittance of the CBD solution may be improved. The filter unit 350 may be replaced less frequently, and the time and cost for maintaining and repairing the filter unit 350 may be reduced.

According to an embodiment of the present disclosure, the cleaning solution used in the cleaning process is discharged through the drainage pipe 322 of the tank 320 by opening a drainage valve 324 formed at (or with) the drainage pipe, after finishing the cleaning process. Here, the drainage valve 324 may be formed at the drainage pipe 322. The CBD solution may be discarded through the drainage pipe 322, and new CBD solution may be filled in the bath 310 through the third pipe 312 by opening the third valve 314.

According to an embodiment of the present disclosure, after forming the buffer layer 140 as described above, the light transmitting electrode layer 150 is formed on the buffer layer 140 to manufacture the solar cell 100.

According to the embodiments of the present invention, the number of times of using the solution for forming the buffer layer is increased when forming the buffer layer by the CBD method.

It should be understood that the example embodiments described herein should be considered in a descriptive sense and not for purposes of limitation. Descriptions of features or aspects within each embodiment should be considered as being available for other similar features or aspects in other embodiments and their equivalents.

## Claims

1. A deposition apparatus (200) comprising:
a bath (210) for holding a solution usable for a chemical bath deposition (CBD) process;
a tank (220) for temporarily storing the solution;
a first pipe (230) fluidly coupling the tank and the bath;
a discharge pump (232) configured to pump the solution through the first pipe (230) from the bath (210) to the tank (220); and
a second pipe (240) fluidly coupling the tank (220) and the bath (210), the second pipe (240) comprising a circulation pump (242) and a filter unit (250), wherein the circulation pump (242) is configured to pump the solution from the tank (220) to the bath (210) via the filter unit (250), through at least the second pipe (240).

2. The deposition apparatus of claim 1, wherein the tank (220) comprises a heater configured to heat the solution stored in the tank to a temperature higher than that of the solution in the bath.

3. The deposition apparatus of claim 1 or 2, wherein the apparatus is configured to move the solution from the bath (210) to the tank (220) when a light transmittance of the solution in the bath is 60% or less.

4. The deposition apparatus of any one of the preceding claims, further comprising:
a first valve (234) in the first pipe (230); and
a second valve (244) in the second pipe (240),
wherein the first valve and the second valve are configured to be in opposite valve positions when moving the solution.

5. The deposition apparatus of any one of the preceding claims, further comprising a circulation pipe (360) fluidly coupling the second pipe (340) and the tank (320)

6. The deposition apparatus of claim 5, further comprising an injection pipe (370) fluidly coupled with the tank, the injection pipe being configured to inject a cleaning solution into the tank (320).

7. A method for recycling a solution, the method comprising:
performing a chemical bath deposition (CBD) process by dipping a substrate in a bath (210) comprising the solution;
determining a light transmittance of the solution;
stopping the CBD process and moving the solution from the bath (210) to a tank (220), when the determined light transmittance of the solution is about 60% or less; and
filtering the solution and moving the filtered solution from the tank back to the bath.

8. The method of claim 7, wherein when the determined light transmittance of the solution is about 60% or less:
the solution is moved from the bath (210) to the tank (220) through a first pipe (230),
the filtered solution is moved from the tank (220) to the bath (210) through a second pipe (240), and
the filtering the solution is performed by a filter unit (250) on the second pipe (240).

9. The method of claim 8, further comprising restarting the CBD process when the filtered solution is moved from the tank to the bath.

10. The method of claim 9, further comprising cleaning the tank and the filter unit after restarting the CBD process.

11. The method of claim 9, wherein the cleaning the tank and the filter unit comprises moving a cleaning solution through a circulation pipe, the circulation pipe fluidly coupling the second pipe and the tank.

12. The method of claim 11, wherein the cleaning solution is deionized water.

13. The method of claim 10, wherein the cleaning the tank and the filter unit comprises:
performing a first cleaning process utilizing an aqueous acid, and
performing a second cleaning process utilizing deionized water.

14. The method of any one of claims 8 to 13, further comprising operating a first valve at the first pipe and a second valve at the second pipe, such that the first valve and the second valve are in opposite valve positions when moving the solution.

15. The method of any one of claims 7 to 14, further comprising setting a temperature of the solution in the tank to a higher temperature than that of the solution in the bath.
